# EUROPEAN PATENT APPLICATION

(11) **EP 1 956 377 A1**
(43) Date of publication of application: **13.08.2008**
(21) Application number: 08250434.1
(22) Date of filing: 06.02.2008
(51) Int. Cl.: G01R 13/02

(54) **Automatic formation of groups of channels**

(30) Priority: 12.02.2007 US 889509 P; 21.11.2007 US 944316
(71) Applicant: Tektronix Inc., Beaverton Oregon 97077-0001 (US)
(72) Inventor: Herring, Steven C., Beaverton, Oregon 97007 (US); Waldo, Gary J., Hillsboro, Oregon 97124 (US); Dobyns, Kenneth P., Beaverton, Oregon 97007 (US)
(74) Representative: Brinck, David John Borchardt

(57) **Abstract**

A method of automatically grouping channels for display uses a pair of multipurpose knobs, one assigned for selection and the other assigned for movement. A channel or a grouping of channels that forms a "virtual group" may be selected from a menu or from a display by the selection knob. The selected channel or virtual group may then be moved to another position on the display by the movement knob. If the movement of the selected channel or virtual group is stopped in proximity to another channel or virtual group, a new virtual group automatically is formed. If movement of the selected channel or virtual group is stopped between proximate channels or within another virtual group, the selected channel or virtual group is inserted automatically between the proximate channels or within the other virtual group to form a new virtual group.

## Description

### BACKGROUND OF THE INVENTION

The present invention relates to multi-channel displays, and more particularly to a method for automatically forming groups from a multitude of data channels.

Some categories of test and measurement instruments, such as logic analyzers (LAs) or mixed signal oscilloscopes (MSOs), provide support for the display of multiple channels of data. Visually organizing this level of detail is cumbersome and tedious for a user. Therefore the multiple channels are organized into groups so that the channels within each group may be managed together, such as by turning on and off the channels associated with a group or moving the channels as a group on the display.

There are two current implementations of channel groups: fixed and user defined. An example of fixed groups is the Agilent MSO6000 series that have two predefined groups of logic channels that may be turned on and off together - D7-D0 and D15-D8. An example of user defined groups is the Tektronix TLA7000 series that allow the user to define a group and have complete control over which channels are included in the group. This is generally done in the form of a checklist where the user calls up a menu and indicates in the menu which channels are grouped. However, for a mixed signal oscilloscope that has position controls normally only for the analog inputs - either two or four channels - to group multiple logic channels together is cumbersome. For example a channel first is assigned to a multipurpose knob which is then used to position the channel on the display. Then another channel is assigned to the multipurpose knob which is then used to position that channel on the display. This process is repeated over and over until each channel has been positioned appropriately.

Therefore what is desired is a method that allows the user to easily and conveniently arrange the display of multiple data channels into desired groups.

### SUMMARY OF THE INVENTION

Accordingly, the present invention provides for automatic grouping of multiple data channels for display that uses a pair of multipurpose knobs, one assigned for selection and the other assigned for movement. A channel or a grouping of channels that forms a group may be selected from a menu or from a display by the selection knob. The selected channel or group may then be moved to another position on the display by the movement knob. If the movement of the selected channel or group is stopped in proximity to another channel or group, a new group automatically is formed. If movement of the selected channel or group is stopped between proximate channels or within another group, the selected channel or group is inserted automatically between the proximate channels or within the other group to form a new group. Likewise, a channel may be removed from a group by selecting the channel and moving it to another position on the display away from the group.

The objects, advantages and other novel features of the present invention are apparent from the following detailed description when read in conjunction with the appended claims and attached drawing.

### BRIEF DESCRIPTION OF THE DRAWING

FIGURE 1 is a plan view of the front of an instrument that includes automatic grouping according to the present invention.

FIGURE 2 is a plan view of a display for the instrument of FIGURE 1 according to the present invention.

FIGURE 3 is a plan view of a portion of the display for the instrument of FIGURE 1 according to the present invention.

FIGURE 4 is a graphic illustrative view showing selecting of channels and groups on the display according to the present invention.

FIGURE 5 is a graphic illustrative view showing turning on channels from a default situation to form groups according to the present invention.

FIGURE 6 is a graphic illustrative view showing movement of individual channels to form groups according to the present invention.

FIGURE 7 is a graphic illustrative view showing further movement of individual channels and groups to form new groups according to the present invention.

### DETAILED DESCRIPTION OF THE DRAWING

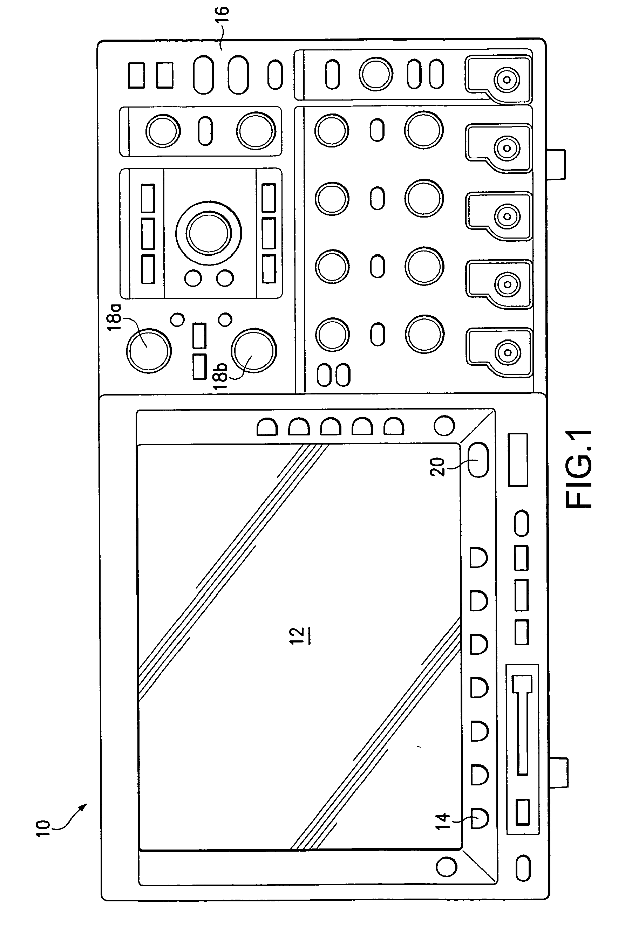

Referring now to FIGURE 1, a plan view of a mixed signal oscilloscope **10** that incorporates automatic grouping of multiple channels for display is shown. The MSO **10** includes a display **12** for displaying analog and/or logic signals, the display including a signal area surrounded by a graphic area. Around the display **12** on a bezel are a plurality of buttons **14** that are associated with functions indicated within the graphic area, as explained in more detail below. Adjacent the display **12** is a control interface **16** that includes in this example two multipurpose knobs **18a, 18b.**

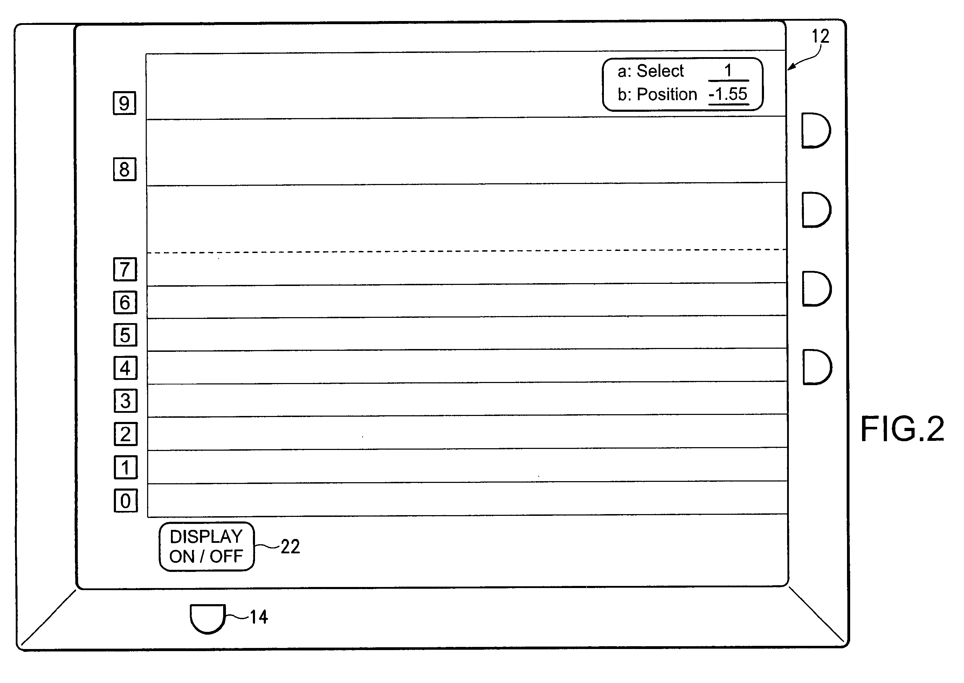

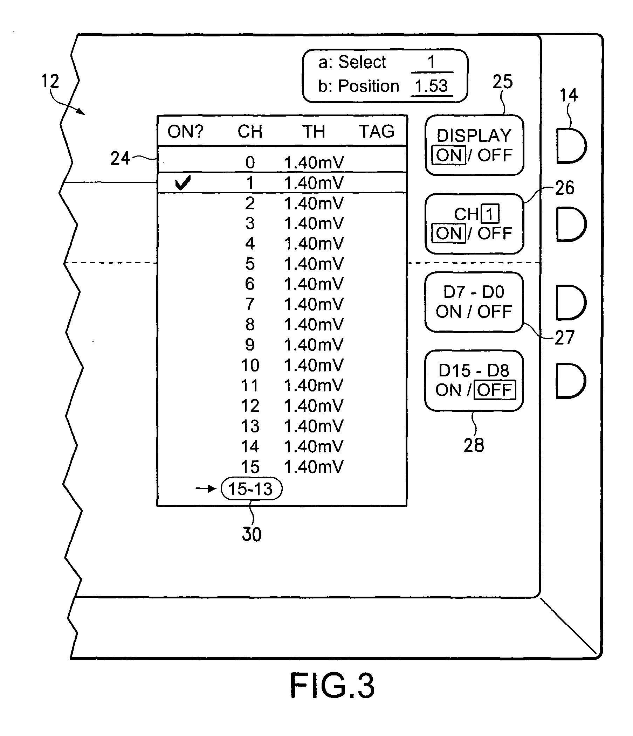

For displaying multiple logic channels, for example sixteen channels, a "D15-D0" button **20** is activated so that selected logic channels may be shown on the display **12.** On the display **12** a channel on/off menu label **22** appears as shown in FIGURE 2 and, by pushing the adjacent button **14,** a menu **24** appears on the display as shown in FIGURE 3 that lists the available channels - D15-DO in this example. The multipurpose knobs **18a, 18b** are assigned one of two functions - Select or Move. For the discussion below the upper multipurpose knob **18a** is assigned as the Select knob and the lower multipurpose knob **18b** is assigned as the Move knob.

Although the following description is based upon the use of knobs, other types of input devices, such as soft keys, mouse ("click" for selecting and "drag" for positioning, for example), etc., may be used for the selecting and positioning functions. The specific device used is not significant, only the function performed.

Turning the Select knob causes respective channels to be highlighted, as is channel 1 shown in FIGURE 3. An indicator, such as a check mark, indicates that the channel is on, while no check mark indicates that the channel is off. A graphic along the right side of the display includes labels **25-28** for turning on/off the menu display, turning on/off the highlighted channel, turning on/off one-half of the channels (D7-D0) as a group or turning on/off the other one-half of the channels (D15-D8) as a group. By pressing the appropriate adjacent button **14** the desired channels may be turned on or off. The channels that are turned on appear in the signal area of the display **12,** as shown in FIGURE 2 where there are channel numbers for channels 0-9. The order in which the channels are displayed may be in an arbitrary order, as the channel when turned on appears at the same position it was when it was last turned off unless settings are returned to a default condition. The default condition may show the channels in numerical order from D0-D15 starting from the bottom of the display **12.**

When a channel on the display **12** is selected by the Select knob **18a,** either from the menu or directly from the display, vertical positioning of the channel on the display is controlled by the Move knob **18b.** The channel number is shown in the graphic area to the left of the channel, and is highlighted when that channel is selected, such as channel 1 in FIGURE 2. The Move knob **18b** moves the selected channel to any desired position on the display **12** within the signal area. When the Move knob **18b** stops, the selected channel also stops. If the display **12** is divided into vertical slots, the selected channel "snaps" into the nearest slot. If the selected channel stops in proximity to another channel, it is then associated with the other channel to form a group. The channels are related as a group only by their proximity on the display, and may be in any arbitrary order. If the selected channel stops within an already formed group of channels between two adjacent channels, it is inserted between the channels and becomes part of the same group. The adjacent channels of the group are moved up/down in order to accommodate the new channel. When a group is formed, it is added as a group **30** to the channel select menu **24,** although only the channels at the ends of the group are shown. The group may be selected by the Select knob **18a,** either from the channel select menu, or by scrolling up the channels of the group on the display **12** until the top channel in the group is reached, such as in FIGURE 2 scrolling up from channel 0 to channel 7. One more "click" in rotation of the Select knob **18a** results in selecting the group, which in this case is channels 0-7. Then the Move knob **18b** moves all of the channels within the selected group as a unit. If the group is positioned in proximity to yet another channel, the new channel is added to the group. If the group is positioned in proximity to another group, the two groups are combined into a new group. If the group is positioned in the middle of another group, the group is inserted into the other group to form a new group.

Therefore, by simply moving individual channels in proximity to each other, the combination of those channels are available for selection and movement together as a group.

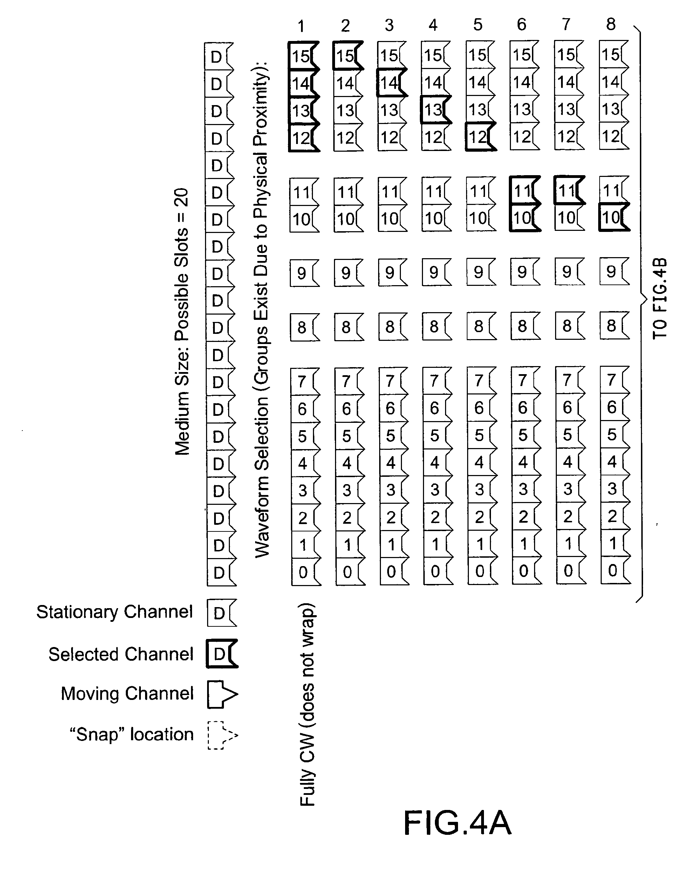

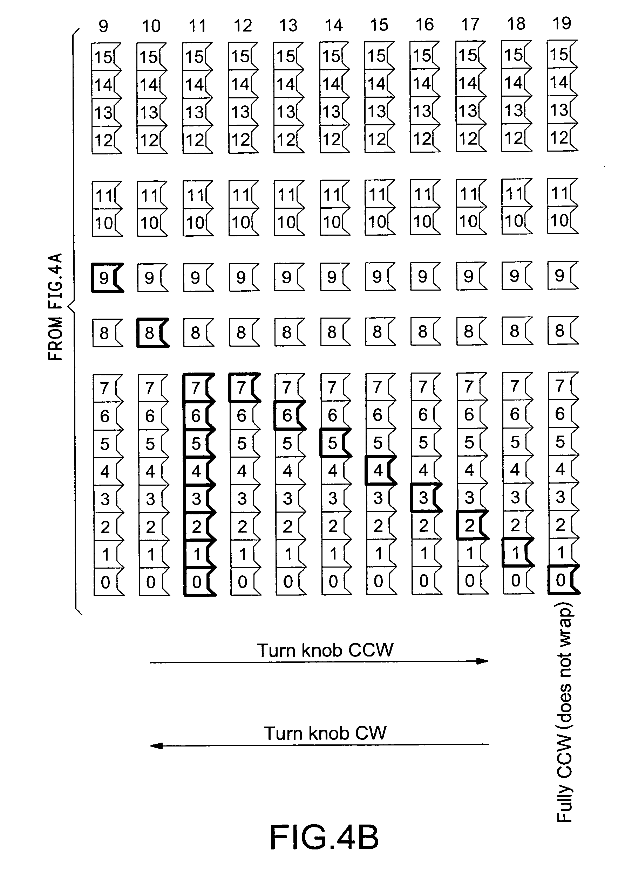

Referring now to FIGURE 4, a conceptual graphic is shown having twenty vertical slots D, with time as the horizontal axis. At the initial time all channels D15-DO are turned on, so all appear on the display. If the Select knob **18a** is at the top of the display **12,** then the top four channels (D15-D12) are selected as a group. As the Select knob **18a** is turned to scroll down the display, each channel (D15-D12) is individually selected in turn until the next grouping of channels D11-D10. The next grouping is then selected before continuing to select each channel individually. After channel D8 is selected, continued scrolling first selects the last groups of channels (D7-D0) before individually selecting each channel in turn. Turning the Select knob **18a** in one direction causes the selection process to scroll down the display **12,** while turning the Select knob in the opposite direction causes the selection process to scroll up the display.

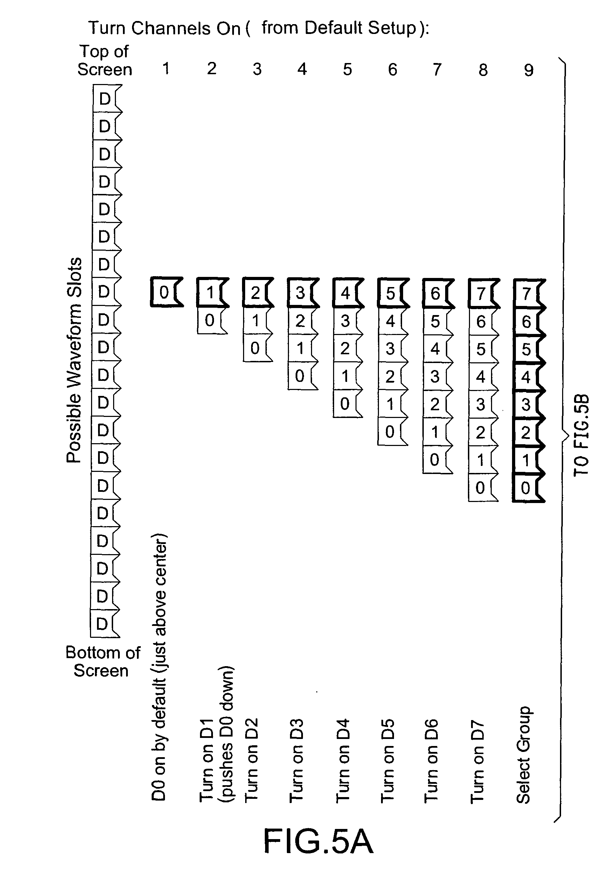

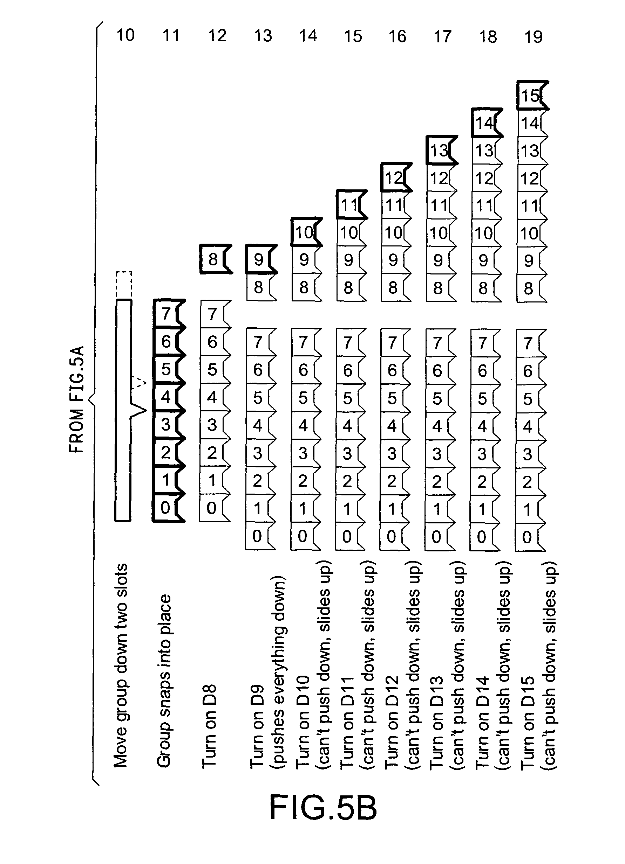

As shown in FIGURE 5, starting with all channels off and from the default situation, the channels may be turned on one by one starting from D0. Initially D0 appears at approximately the midpoint of the display **12,** indicated by the dotted line in Figs. 2 and 3. As each new channel is turned on in sequence, it is placed at the midpoint of the display **12** and the prior channel(s) are pushed down on the display. Each new channel is added to the existing group until a desired group (D7-D0) is formed. Alternatively, the first half of the channels (D7-D0) may be turned on together by the button **14** opposite the appropriate graphic on the display **12** shown in FIGURE 3. At this point, the group may be selected and moved down so as not to be in proximity to the midpoint. Then, the remaining channels are selected in sequence to form a second group, pushing all lower channels down until the bottom of the display **12** is reached. At that point the new channels being turned on are added to the top of the prior selected channel.

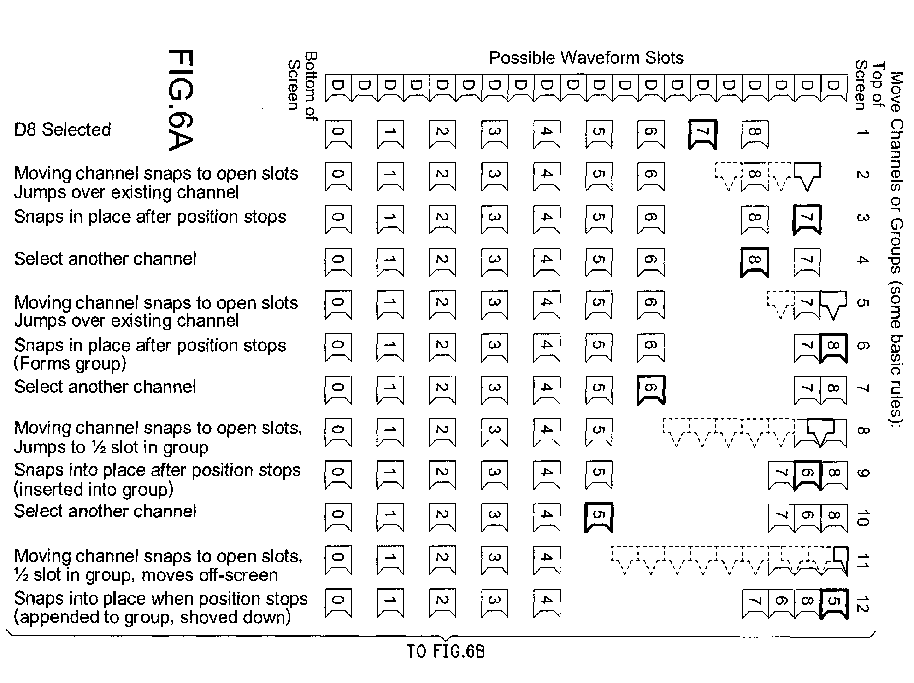

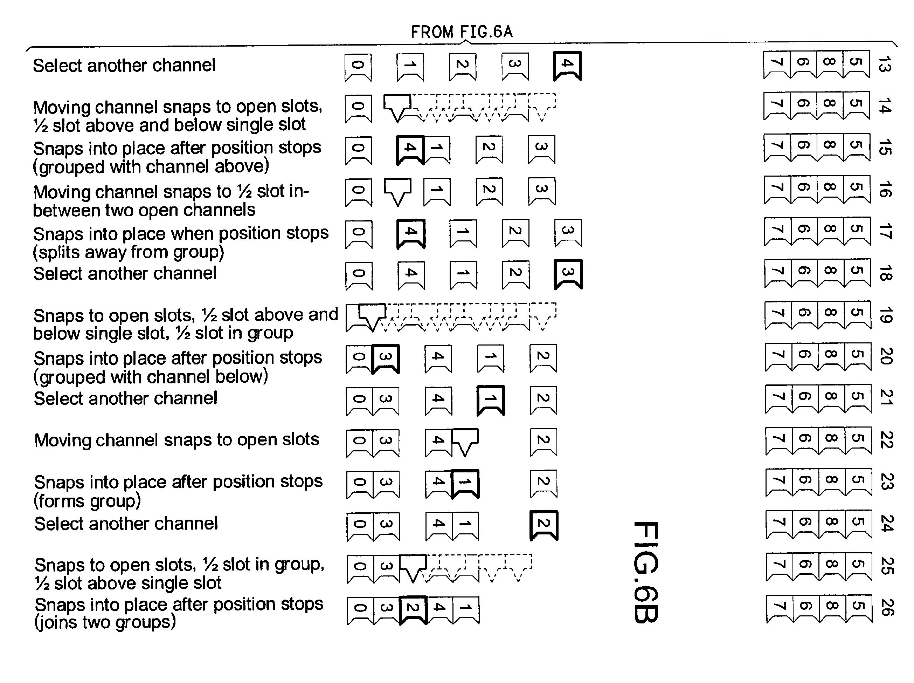

FIGURE 6 illustrates a process where several channels (D8-D0) are turned on, but none are positioned in proximity to each other, so that no groups exist. Initially, one channel D7 is moved out of numerical sequence by moving it above an upper channel D8. Since, when D7 stopped moving, it is not adjacent to another channel, no grouping is formed. However, when D8 is moved above and in proximity to D7, a grouping is formed. Then, D6 is selected and moved to be between D8 and D7, and it is inserted into the group between the preexisting channels of the grouping. Likewise, D5 may be added to the top of the group, pushing the other channels down in this instance to provide a grouping in order from top to bottom of D5, D8, D6, D7 at the top of the display **12.** The remaining channels D4-DO are then grouped in a similar manner at the bottom of the display **12** in order of D1, D4, D2, D3, D0.

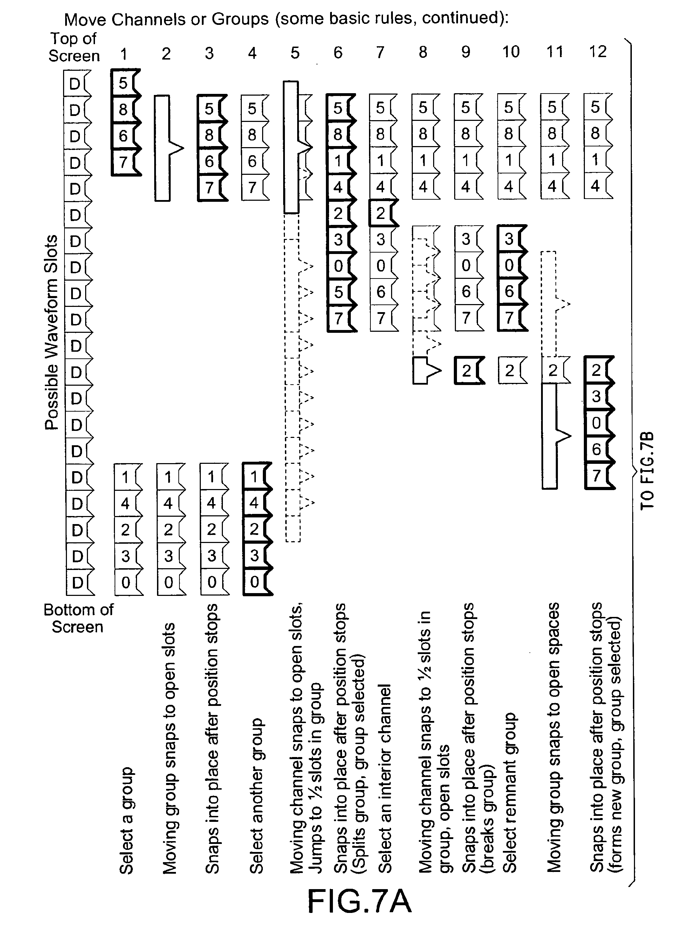

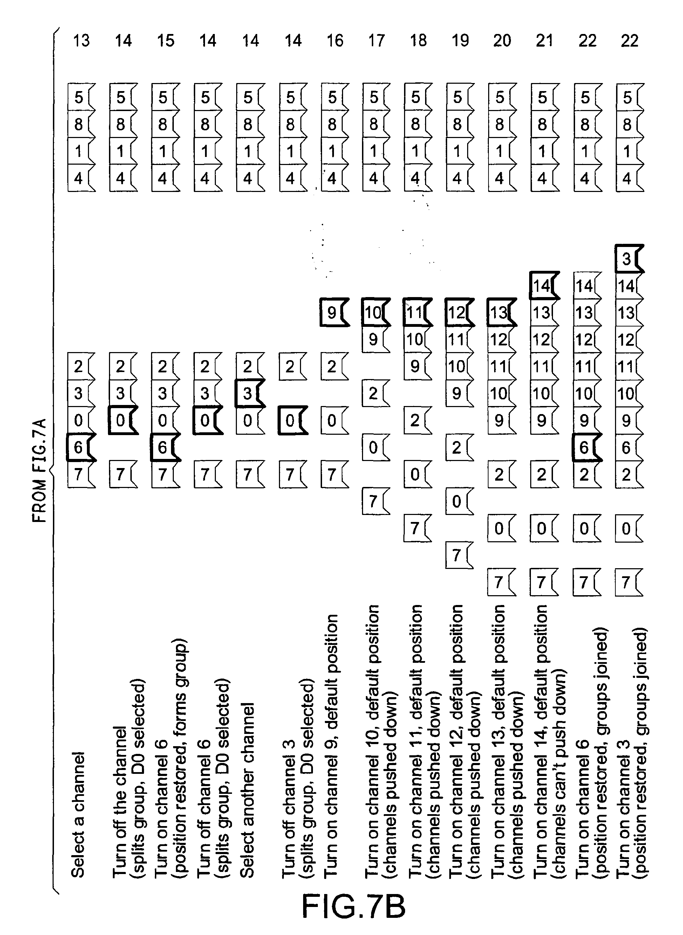

FIGURE 7 illustrates moving groups, the top group being moved down one slot and then the bottom group being moved up to form a new group that is the combination of the two groups, the bottom group being inserted into the middle of the top group. Then, one channel (D2) in the middle is selected and moved out of the group to form two groups and a single channel. The lower group is then moved below the single channel so that D2 is at the top of the group. Then, one of the channel (D6) in the lower group is turned off, which splits the group - the channel (D0) above the turned off channel being automatically selected. When the off channel is turned on, it appears at the same location as previously. Now, as new channels are turned on in default positions, they are added at the midpoint of the display **12** and push the existing channels down until the lowest channel is at the bottom of the display. Then, the new channels are added to the top of the newly created group. At some point, one of the turned off channels (D6) is turned on and appears where it previously was. Since D6 is now in proximity to both the new group (D14-D9) and D2, both D6 and D2 are added to the grouping. Finally, the last channel (D15) is turned on, resulting in two groupings (D5-D4 and D15-D2) and two single channels (D0 and D7).

Although the present invention is described above in terms of logic signals and their vertical positioning, any type of signals or data that is divided into channels may be manipulated in the same manner. Also for vertical displays, as opposed to the horizontal display illustrated, the movement of channels may be along the horizontal axis as opposed to the vertical axis. "Proximity" may be defined by slot intervals or pixel displacement on the display.

Thus, the present invention provides a method of automatically grouping channels as defined by a user that is unrelated to decode busses, the channels being turned on and moved on a display to form arbitrary groups when the movement stops in proximity to other channels, which groups may then be moved as a unit on the display.

## Claims

1. A method of automatically forming groups from a plurality of data channels comprising the steps of:
selecting channels from the plurality of data channels for display;
moving one of the displayed channels adjacent another displayed channel to form a group.

2. The method as recited in claim 1 further comprising the step of moving the group in proximity to another group to form a new group that is the combination of the two groups.

3. The method as recited in claim 1 wherein the selected channel in the moving step is positioned in proximity to two other channels for insertion between the two other channels to form the group.

4. The method as recited in claim 2 wherein the group in the moving step is positioned for insertion into the other group to form the new group.

5. The method as recited in claim 1 wherein the group in the moving step is positioned adjacent another channel to form the new group.

6. A test and measurement instrument operable to receive and display a plurality of data channels, the test and measurement apparatus comprising:
means for displaying one or more of a plurlity of received data channels;
means for selecting channels from the plurality of data channels for display; and
means for moving one of the displayed channels on the display means,
wherein in response to the moving means moving a displayed channel adjacent to one or more other displayed channels, the test and measurement instrument is operable to form a group of channels comprising said moved channel and said one or more adjacent channels.

7. A test and measurement instrument according to claim 6, further comprising:
means for determining if a moved channel satisfies a criterion for adjacency with regard to other displayed channels; and
means for creating a group comprising the moved channel and any other channel for which the determining means determines that the criterion for adjacency is satisfied.

8. A test and measurement instrument according to claim 6 or 7, wherein said selecting means is operable to select a group of channels for manipulation by a user.
